(19) Europäisches Patentamt

European Patent Office

Office européen des brevets

(11) **EP 1 677 308 A1**

(12) **EUROPEAN PATENT APPLICATION**

(43) Date of publication:
**05.07.2006 Bulletin 2006/27**

(51) Int Cl.:
***G11C 5/14*** *(2006.01)*

(21) Application number: **05425001.4**

(22) Date of filing: **03.01.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(71) Applicants:
• **STMicroelectronics S.r.l.**
  **20041 Agrate Brianza (Milano) (IT)**
• **Hynix Semiconductor Inc.**
  **Kyoungki-do (KR)**

(72) Inventors:
• **Ragone, Giancarlo**
  **89047 Roccella Ionica (IT)**
• **Sangalli, Miriam**
  **20061 Carugate (IT)**
• **Micheloni, Rino**
  **22078 Turate (IT)**

(74) Representative: **Pellegri, Alberto et al**
  **c/o Società Italiana Brevetti S.p.A.**
  **Piazza Repubblica, 5**
  **21100 Varese (IT)**

(54) **Low-ripple boosted voltage generator**

(57)   The output voltage ripple of a single stage or a multi-stage charge pump is significantly reduced by introducing in the voltage generator a cascode connected output transistor. In operation, this output transistor is always in a conduction state and is controlled with a voltage having a smaller ripple than the voltage output by the charge pump.

**FIG. 1**

**Description**

FIELD OF THE INVENTION

This invention relates to boosted voltage generators and more particularly to a boosted voltage generator with a reduced peak-to-peak ripple.

BACKGROUND OF THE INVENTION

Charge pumps are widely used for generating a voltage larger than the available supply voltage. These generators are used, for example, in FLASH memory devices for reading or writing memory cells, or also for powering certain electronic circuits at a specified boosted voltage.

Typically, charge pumps are composed of a certain number N of stages connected in cascade and the output voltage $V_{OUT}$ generated by the last stage is a multiple of the supply voltage $V_{dd}$ according to the following equations:

$$V_{OUT} = (N+1) \cdot V_{dd} \qquad \text{or} \qquad V_{OUT} = -N \cdot V_{dd}$$

depending on whether the output voltage is positive or negative.

Therefore, the number of stages N of a multi-stage charge pump is established in function of the voltage to be generated.

Commonly, the supply voltage is not constant but varies in a certain range. In order to generate a constant voltage $V_{OUT}$, it is necessary to provide the charge pump with a regulation circuit of its output voltage. This regulation circuit compares the output voltage $V_{OUT}$ with a reference voltage and stops switching the stages of the charge pump when the output voltage crosses the reference voltage.

The output voltage so generated is affected by a relevant ripple in correspondence of the nominal output voltage of the charge pump. This ripple, that may be even 1V peak-to-peak large, is a non negligible problem in multi-level FLASH memory devices, and may lead to erroneous operations. Indeed, in multi-level memory devices a maximum ripple of only few tens of millivolts is allowed.

Charge pumps are also used for powering linear voltage regulators with a controlled voltage. The ripple of this controlled voltage reduces the precision of voltage regulators particularly when the powered regulators do not have a relatively large PSRR (Power Supply Rejection Ratio).

SUMMARY OF THE INVENTION

It has been found a simple architecture of a voltage generator that generates a boosted voltage with a reduced ripple and a method of reducing the ripple of a boosted voltage.

According to the invention, the output voltage ripple of a single stage or a multi-stage charge pump is significantly reduced by introducing in the voltage generator a cascode connected output transistor. In operation, this output transistor is always in a conduction state and is controlled with a voltage having a smaller ripple than the voltage output by the charge pump.

More precisely, this invention provides a method of reducing the ripple of a boosted voltage and a relative generator of a boosted voltage, comprising a charge pump generating a controlled voltage at the output of the last stage of the charge pump. The generator of this invention generates a boosted voltage with a relatively small ripple by virtue of a cascode connected output transistor, the current terminals of which are connected to the output of a stage of the charge pump and to an output node of the generator, respectively, and having a control node coupled to a voltage, less corrupted by ripple than the controlled voltage, that maintains the output transistor in a conduction state.

The invention is defined in the annexed claims.

BRIEF DESCRIPTION OF THE DRAWINGS

The various features and advantages of the invention will be even more evident through a detailed description of several embodiments referring to the attached drawings, wherein:

**Figure 1** depicts a first embodiment of a generator of this invention;
**Figure 2** depicts the architecture of each stage of the charge pump of Figure 1;

**Figure 3** depicts a voltage dividing low-pass filter;

**Figure 4** is a low-pass filter of the control voltage of the output cascode connected transistor of Figure 1;

**Figure 5** depicts a second embodiment of the generator of this invention with a switch for connecting the control node of the output transistor to any intermediate node of the charge pump;

**Figure 6** depicts a third embodiment of the generator of this invention having a plurality of output cascode connected transistors;

**Figure 7** depicts sample time evolutions of the main voltages of the generator of Figure 1.

DESCRIPTION OF SEVERAL EMBODIMENTS OF THE INVENTION

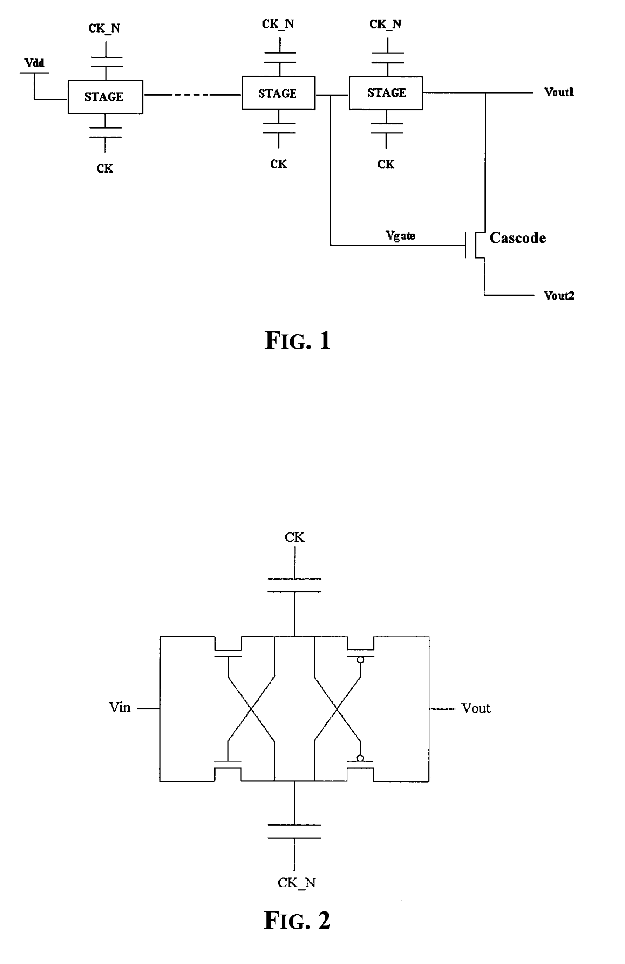

A first architecture of a boosted voltage generator of this invention is depicted in Figure 1. In practice, it is composed substantially of a multi-stage charge pump and of a cascode connected output transistor CASCODE between the output of the charge pump and the output node of the generator of the boosted voltage Vout2. According to the method of the invention, the ripple of the boosted voltage is reduced by controlling the output transistor CASCODE with a voltage Vgate affected by a ripple smaller than that of the controlled voltage Vout1 output by the charge pump, and such to keep the output transistor CASCODE in a conduction state.

The invention is described referring to the case in which the cascode connected output transistor is a MOS transistor, but the same considerations apply *mutatis mutandis* for a BJT transistor.

Preferably the charge pump is a multi-stage charge pump and the voltage Vgate is generated by any common node between two stages of the multi-stage charge pump.

If the charge pump generates a positive voltage, the output transistor CASCODE must be a N-channel transistor, otherwise a P-channel transistor in the opposite case. In so doing, the transistor never disconnects a supplied load from the charge pump, but simply acts for reducing the ripple of the controlled voltage generated by the charge pump.

Indeed, the boosted voltage Vout2 is tied to the control voltage Vgate according to the following equation:

$$Vout2 = Vgate - Vth$$

Therefore, the cascode connected output transistor CASCODE reduces effectively the ripple of the generated boosted voltage Vout2 because, when the controlled voltage Vout1 (that is the drain potential) increases, the gate voltage remains substantially constant, and so does the boosted voltage Vout2.

Preferably, the control voltage of the output transistor CASCODE is the voltage on the connection node between the last and the before last stage of the charge pump. A boosted voltage generator in which the control node of the output transistor is connected to any other common node of two consecutive stages of the multi-stage charge pump is less convenient than the solution depicted in Figure 1, if the largest possible boosted voltage Vout2 is to be generated.

If each stage of the charge pump is a voltage doubler, as depicted in Figure 2, the control node of the cascode connected transistor may be conveniently connected directly to a common node between two adjacent stages of the charge pump, because the voltage ripple is relatively small. Otherwise, it is preferable to filter this voltage with a low pass filter such that shown in Figure 4.

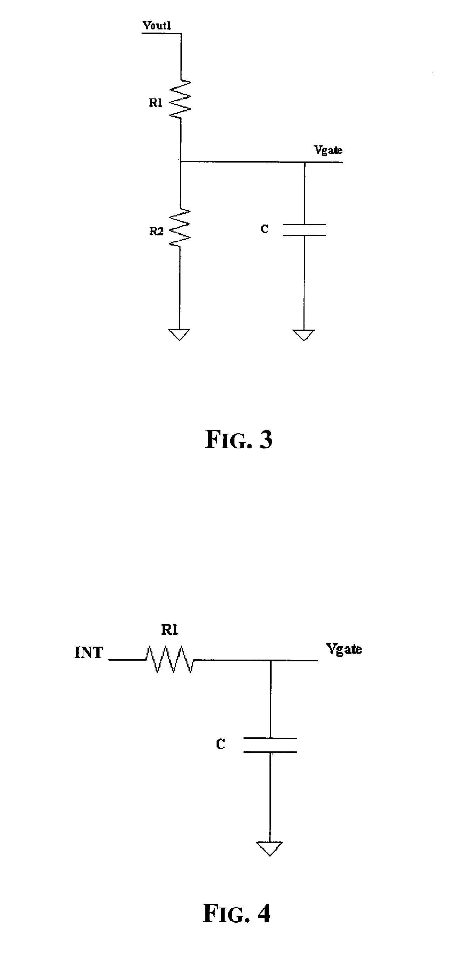

As an alternative, the control voltage Vgate of this output transistor CASCODE may be generated by filtering the controlled voltage Vout1 of the charge pump with a voltage dividing low-pass filter of Figure 3.

In this particular case, the generator of the invention may be realized even with a single-stage charge pump. Indeed, a multi-stage charge pump is needed only when the control terminal of the cascode transistor is connected to a common node between two consecutive stages of the charge pump.

If the transistor is perfectly symmetrical, the output node of the generator may be the drain or the source terminal of the transistor. By contrast, if the transistor is not symmetrical, the output node of the generator must be the source or the drain terminal depending on whether a NMOS or a PMOS is used, respectively.

According to a preferred embodiment of this invention, the cascode connected output transistor is a natural transistor, that is a transistor with a very small threshold voltage Vth. As stated before, the boosted voltage is given by the following equation

$$Vout2 = Vgate - Vth$$

thus it is desirable to use a natural transistor if a boosted voltage Vout2 with the largest possible value is desired.

Preferably, the cascode connected transistor is a high-voltage transistor, because it may withstand voltages larger than the supply voltage of the generator.

According to an alternative embodiment, the current terminal of the output transistor CASCODE coupled to the voltage Vout1, may be coupled to the voltage output by any intermediate stage of the charge pump.

A second embodiment of the generator of this invention is depicted in Figure 5. Differently from the generator of Figure 1, it has a switch HV SWITCH for connecting the control node of the cascode connected transistor to any intermediate stage of the multi-stage charge pump. An advantage of this architecture consists in that it is possible to vary the generated boosted voltage according to the needs.

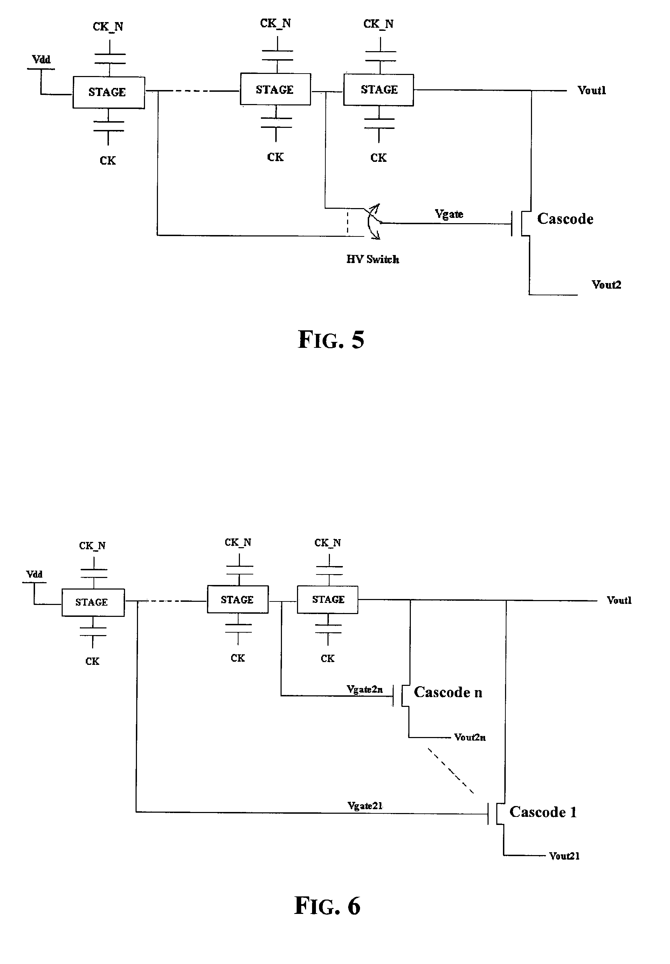

An alternative embodiment to the architecture of Figure 5 is that depicted in Figure 6. It has a plurality of cascode connected transistors each controlled by the voltage on a respective intermediate node of the charge pump, each generating a respective output boosted voltage. Obviously, the same considerations and variations that may be carried out to the architecture of Figure 1 apply also for the embodiments of Figures 5 and 6.

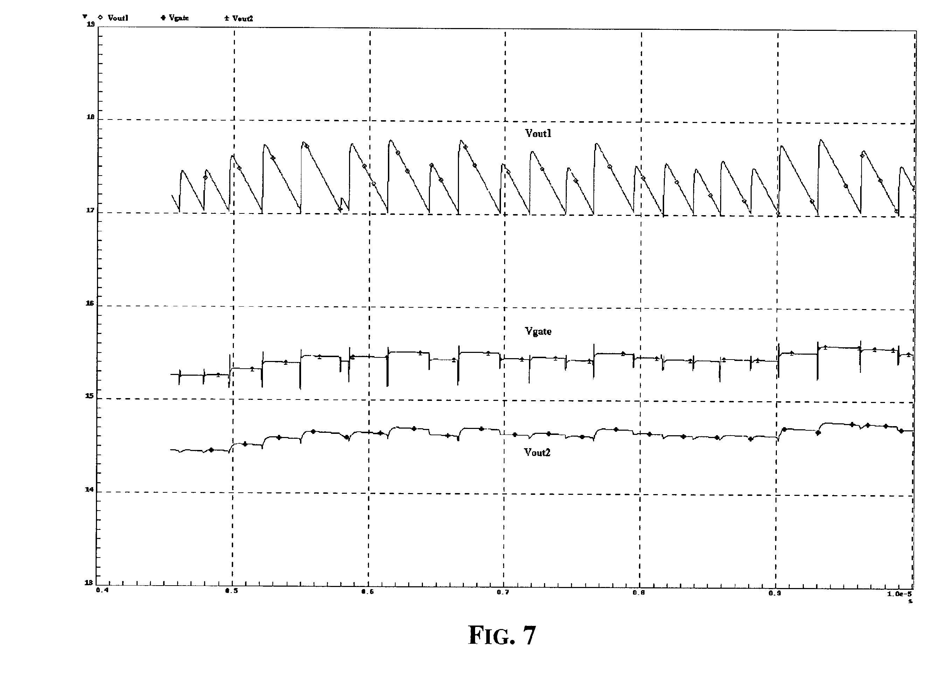

The time diagrams of Figure 7, obtained by simulating the functioning of the generator of Figure 1, wherein all the stages are as depicted in Figure 2, show clearly that the generated boosted voltage Vout2 is affected by a smaller ripple than the controlled voltage Vout1 generated by the charge pump.

**Claims**

1. A generator of a boosted voltage (Vout2), comprising a charge pump generating a controlled voltage (Vout1) at the output of a last stage of the charge pump, **characterized in that** it comprises a cascode connected output transistor (CASCODE), the current terminals of which are connected to the output of a stage of the charge pump and to an output node (Vout2) of the generator, respectively, and having a control node coupled to a voltage (Vgate), less corrupted by ripple than said controlled voltage (Vout1), that maintains said cascode connected output transistor (CASCODE) in a conduction state.

2. The generator of claim 1, wherein a current terminal of said cascode connected output transistor (CASCODE) is connected to the output of the last stage of the charge pump.

3. The generator of claim 1, wherein said charge pump is a multi-stage charge pump and the control node of the cascode connected output transistor (CASCODE) is coupled to a connection node between two stages of said charge pump onto which a fraction of said controlled voltage (Vout1) is generated.

4. The generator of claim 1, comprising a voltage dividing low-pass filter of said controlled voltage (Vout1) generating said voltage (Vgate) to which the control node of the cascode connected output transistor (CASCODE) is coupled.

5. The generator of claim 1 for generating a plurality of boosted voltages on respective output nodes, wherein said charge pump is a multi-stage charge pump, the generator comprising a plurality of cascode connected output transistors (CASCODE 1, CASCODE N), a current terminal of which is connected to the output of a stage of the multi-stage charge pump and the other current terminals are connected to a respective output node of the generator, the control node of which is coupled to a respective voltage, less corrupted by ripple than said controlled voltage (Vout1), that maintains said output transistor in a conduction state.

6. The generator of claim 1, wherein the charge pump generates a positive boosted voltage (Vout2) in respect to the potential of a common ground node of the generator, and said cascode connected output transistor (CASCODE) is a N-channel MOS transistor (N-Ch).

7. The generator of claim 1, wherein the charge pump generates a negative boosted voltage (Vout2) in respect to the potential of a common ground node of the generator, and said cascode connected output transistor (CASCODE) is a P-channel MOS transistor.

8. The generator of claim 1, wherein said cascode connected output transistor is a natural MOS transistor.

9. The generator of claim 3, comprising a switch for connecting the control node of said cascode connected output transistor (CASCODE) selectively to any connection node between two stages of said charge pump in function of a desired boosted voltage to be generated.

10. The generator of claim 3, wherein said control node is coupled to the connection node between the last and the before last stage of the charge pump.

**11.** The generator of claim 3, further comprising a low-pass filter of the voltage of said connection node generating said voltage (Vgate) to which the control node of the cascode connected output transistor (CASCODE) is coupled.

**12.** A method of reducing the ripple of a boosted voltage generated with a charge pump generating a controlled voltage (Vout1) at the output of a last stage of the charge pump and with a cascode connected output transistor (CASCODE), the current terminals of which are connected to the output of the last stage of the charge pump and to an output node (Vout2) of the generator, respectively, comprising the step of controlling said cascode connected output transistor (CASCODE) with a voltage (Vgate), less corrupted by ripple than said controlled voltage (Vout1), that maintains said cascode connected output transistor (CASCODE) in a conduction state.

**FIG. 1**

**FIG. 2**

FIG. 3

FIG. 4

FIG. 5

FIG. 6

FIG. 7

EP 1 677 308 A1

**European Patent Office**

## EUROPEAN SEARCH REPORT

Application Number

EP 05 42 5001

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2001/012219 A1 (LEE BYEONG-HOON ET AL) 9 August 2001 (2001-08-09) | 1,2,6,12 | G11C5/14 |
| Y | * paragraphs [0007] - [1012]; figures 1,2,4,5 * | 6-8 | |
| Y | US 6 707 755 B1 (SOMASEKHAR DINESH ET AL) 16 March 2004 (2004-03-16) * column 3, line 18 - column 4, line 6; figure 3 * | 6-8 | |
| A | US 2003/071679 A1 (KONO TAKASHI ET AL) 17 April 2003 (2003-04-17) * paragraph [0141]; figure 6 * | 3,4,11 | |
| A | US 6 163 487 A (GHILARDELLI ET AL) 19 December 2000 (2000-12-19) * column 2, line 47 - column 6, line 8; figure 1 * | 3,4,11 | |

TECHNICAL FIELDS SEARCHED (Int.Cl.7)

G11C

The present search report has been drawn up for all claims

| Place of search | Date of completion of the search | Examiner |
|---|---|---|
| The Hague | 29 April 2005 | Wolff, N |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 05 42 5001

This annex lists the patent family members relating to the patent documents cited in the above-mentioned European search report.
The members are as contained in the European Patent Office EDP file on
The European Patent Office is in no way liable for these particulars which are merely given for the purpose of information.

29-04-2005

| Patent document cited in search report | | Publication date | Patent family member(s) | | Publication date |
|---|---|---|---|---|---|
| US 2001012219 | A1 | 09-08-2001 | KR 2001077519 A<br>JP 2001229687 A | | 20-08-2001<br>24-08-2001 |
| US 6707755 | B1 | 16-03-2004 | NONE | | |
| US 2003071679 | A1 | 17-04-2003 | JP 11288588 A<br>US 2001001545 A1<br>US 6201437 B1 | | 19-10-1999<br>24-05-2001<br>13-03-2001 |
| US 6163487 | A | 19-12-2000 | NONE | | |

EPO FORM P0459

For more details about this annex : see Official Journal of the European Patent Office, No. 12/82